# EUROPÄISCHE PATENTSCHRIFT

(11) **EP 1 658 647 B1**
(45) Veröffentlichungstag und Bekanntmachung des Hinweises auf die Patenterteilung: **18.02.2009**
(21) Anmeldenummer: 04786185.1
(22) Anmeldetag: 24.08.2004
(51) Int. Cl.: H01L 51/10, H01B 3/18

(54) **INTEGRIERTE SCHALTUNG MIT EINEM ORGANISCHEN HALBLEITER UND VERFAHREN ZUR HERSTELLUNG EINER INTEGRIERTEN SCHALTUNG**
INTEGRATED CIRCUIT COMPRISING AN ORGANIC SEMICONDUCTOR, AND METHOD FOR THE PRODUCTION OF AN INTEGRATED CIRCUIT
CIRCUIT INTEGRE COMPORTANT UN SEMI-CONDUCTEUR ORGANIQUE ET PROCEDE DE FABRICATION D'UN CIRCUIT INTEGRE

(30) Priorität: 29.08.2003 DE 10340608
(43) Veröffentlichungstag der Anmeldung: 24.05.2006
(73) Patentinhaber: Infineon Technologies AG, 81669 München (DE)
(72) Erfinder: HALIK, Marcus, 91058 Erlangen (DE); KLAUK, Hagen, 70195 Stuttgart (DE); SCHMID, Günter, 91334 Hemhofen (DE); WALTER, Andreas, 01109 Dresden (DE); ZSCHIESCHANG, Ute, 70195 Stuttgart (DE)
(74) Vertreter: Gross, Felix
(86) Internationale Anmeldenummer: PCT/DE2004/001903
(87) Internationale Veröffentlichungsnummer: WO 2005/023940

(56) Entgegenhaltungen:
- B. RECK, R. D. ALLEN, R. J. TWIEG, C. G. WILLSON, S. MATUSZCZAK, H. D. H. STOVER, N. H. LI, J. M. J. FRÉCHET: "Novel photoresist design based on electrophilic aromatic substitution" POLYMER ENGINEERING AND SCIENCE, Bd. 29, Nr. 14, 1989, Seiten 960-964, XP009044320
- LEE, S. MING ET AL: "Photocrosslinking of Poly(4-hydroxystyrene) via Electrophilic Aromatic Substitution: Use of Polyfunctional Benzylic Alcohols in the Design of Chemically Amplified Resist Materials with Tunable Sensitivities" MACROMOLECULES , 27(18), 5154-9 CODEN: MAMOBX; ISSN: 0024-9297, 1994, XP002318415
- FAHEY, J. T. ET AL: "Resist system based on the cationic photocrosslinking of poly(4-hydroxystyrene) and polyfunctional electrophiles" JOURNAL OF POLYMER SCIENCE, PART A: POLYMER CHEMISTRY , 31(1), 1-11 CODEN: JPACEC; ISSN: 0887-624X, 1993, XP002318416

## Beschreibung

Die Erfindung betrifft eine integrierte Schaltung nach dem Oberbegriff des Anspruchs 1 und ein Verfahren zur Herstellung einer integrierten Schaltung mit einem organischen Halbleiter nach Anspruch 9.

System mit integrierten Schaltungen basierend auf organischen Halbleitern, insbesondere organischen Feldeffekttransistoren (OFET) stellen eine zukunftsträchtige Technologie im Massenanwendungsbereich preiswerter Elektronik dar. Ein Feldeffekttransistor gilt insbesondere als organisch, wenn die halbleitende Schicht aus einem organischen Material hergestellt ist.

Da sich mit OFETs komplexe Schaltungen aufbauen lassen, bestehen zahlreiche Anwendungsmöglichkeiten. So gilt beispielsweise die Einführung von RF-ID (RF-ID: radio frequency identification) Systemen basierend auf dieser Technologie als potentieller Ersatz für den störanfälligen und nur in direktem Sichtkontakt zum Scanner anwendbaren Barcode.

Besonders Schaltungen auf flexiblen Substraten, die in hohen Stückzahlen im Rolle-zu-Rolle Verfahren gefertigt werden können, sind hierbei von Interesse.

Für die Herstellung solcher flexiblen Substrate besteht aufgrund des thermischen Verzuges der meisten in Frage kommenden preiswerten Substrate (z.B. Polyethylenterephthalat (PET), Polyethylennaphtalat (PEN)) eine obere Temperaturgrenze von 130 - 150°C. Unter bestimmten Vorraussetzungen, z.B. einer thermischen Vorbehandlung des Substrates, lässt sich diese Temperaturgrenze bis auf 200°C erhöhen, jedoch mit der Einschränkung, dass der Verzug des Substrates zwar reduziert, nicht jedoch verhindert wird.

Ein kritischer Prozessschritt bei elektronischen Bauelementen ist die Abscheidung der Dielektrikumsschicht, insbesondere der Gatedielektrikumsschicht eines OFET. An die Qualität der Dielektrika in OFETs werden hinsichtlich der thermischen, chemischen, mechanischen und elektrischen Eigenschaften sehr hohe Ansprüche gestellt.

Siliziumdioxid (SiO₂) stellt das derzeit häufigst verwendete Gatedielektrikum in OFETs dar, basierend auf der breiten Verfügbarkeit in der Halbleitertechnologie. So sind Transistorstrukturen beschrieben, bei denen ein dotierter Siliziumwafer als Gateelektrode dient und darauf thermisches aufgewachsenes SiO₂ das Gatedielektrikum bildet. Dieses SiO₂ wird bei Temperaturen von etwa 800 - 1000°C hergestellt. Andere Prozesse (z.B. CVD) zur Abscheidung von SiO₂ auf verschiedenen Substraten arbeiten ebenfalls bei Temperaturen oberhalb von 400°C. Eine Gruppe an der PennState University hat einen Prozess (Ionenstrahl Sputtern) entwickelt, der es erlaubt, ein qualitativ hochwertiges SiO₂ bei Prozesstemperaturen von 80°C abzuscheiden. Dies ist in den Artikeln von C. D. Sheraw, J. A. Nichols, D. J. Gundlach, J. R. Huang, C. C. Kuo, H. Klauk, T. N. Jackson, M. G. Kane, J. Campi, F. P. Cuomo, and B. K. Greening, Tech. Dig. -lot. Electron Devices Meet., 619 (2000) und C. D. Sheraw, L. Zhou, J. R. Huang, D. J. Gundlach, T. N. Jackson, M. G. Kane, I. G. Hili, M. S. Hammond, J. Campi, B. K. Greening, J. Francl, and J. West, Appl. Phys. Lett. 80, 1088 (2002) beschrieben.

Nachteilig hierbei sind jedoch die hohen Prozesskosten und der geringe Durchsatz für Massenprodukte.

Es ist auch bekannt, anorganische Nitride, wie z.B. SiN_{x'}, TaNₓ zu verwenden. Ähnlich der Herstellung von anorganischen Oxiden, erfordern die Abscheidungen von anorganischen Nitriden hohe Temperaturen bzw. hohe Verfahrenskosten. Dies ist z.B. in dem Artikel von B. K. Crone, A. Dodabalapur, R. Sarpeshkar, R. W. Filas, Y. Y. Lin, Z. Bao, J. H. O'Neill, W. Li, and H. E. Katz, J. Appl. Phys. 89,5125 (2001) beschrieben.

Auch ist es bekannt, Hybridlösungen (spin on glass) zu verwenden. Organische Siloxane, die sich aus einer Lösung herstellen lassen und durch eine thermische. Konvertierung in "glasähnliche" Schichten umwandeln lassen, wurden beschrieben. Die Konvertierung zu SiO₂ erfolgt entweder bei hohen Temperaturen (ca. 400°C) oder verläuft nur teilweise, was eine verringerte Transistorqualität zur Folge hat (siehe dazu den Artikel von Z. Bao, V. Kuck, J.A. Rogers, and M.A. Paczkowski, Adv. Funct. Mater., 12,526, (2002).

Außerdem sind bereits organische Polymere, wie zum Beispiel Poly-4-vinylphenol (PVP), Poly-4- vinylphenol-co-2-hydroxyethylmethacrylat oder Polyimid (PI) verwendet worden. Diese Polymere zeichnen sich durch ihre vergleichsweise einfache Verarbeitbarkeit aus. So sind sie z.B. aus der Lösung für spin-coating oder Drucken verwendbar. Die hervorragenden dielektrische Eigenschaften solcher Materialien sind bereits demonstriert worden (siehe Artikel von H. Klauk, M. Halik, U. Zschieschang, G. Schmid, W. Radlik, and W. Weber, J Appl. Phys., in press, scheduled to appear in val. 92, no. 10 (November 2002))

Auch Anwendungen in Interconnectschichten (ICs) konnten bereits demonstriert werden, wobei die benötigten chemischen und mechanischen Stabilitäten der Dielektrikumsschichten für deren Strukturierung und die Strukturierung der darauffolgenden Source-Drain-Schicht durch Quervernetzung der Polymere erreicht wurde (siehe Artikel von M. Halik, H. Klauk, U. Zschieschang, T. Kriem, G. Schmid, and W. Radlik, Appl. Phys. Lett., 81, 289 (2002)).

Diese Quervernetzung erfolgt jedoch bei Temperaturen von 200°C, was für die Herstellung großflächiger flexibler Substrate problematisch ist.

Der vorliegenden Erfindung liegt die Aufgabe zugrunde, eine integrierte Schaltung mit einem organischen Halbleiter und ein Verfahren zu schaffen, wobei die Herstellung von Dielektrikumsschichten von OEFT's bei niedrigen Temperaturen möglich ist.

Diese Aufgabe wird erfindungsgemäß durch ein Verfahren mit den Merkmalen des Anspruchs 1 gelöst.

Erfindungsgemäß ist die integrierte Schaltung mit einem organischen Halbleiter aus einer Polymerformulierung bestehend aus
a) 100 Teilen mindestens eines vernetzbaren Basispolymers,
b) 10 bis 20 Teilen mindestens einer Di- bzw. Tribenzylalkoholverbindung als elektrophile Vernetzerkomponente,
c) 0,2 bis 10 Teilen mindestens eines Photosäuregenerators und
d) mindestens ein Lösungsmittel
herstellbar. Die erfinduhgsgemäßen integrierten Schaltungen sind insbesondere OFETs mit organischen Schichten, die hervorragende Dielektrikumseigenschaften aufweisen. Die integrierten Schaltungen sind auf Grund der verwendeten spezifischen Polymerformulierung in einfacher Weise bei niedrigen Temperaturen (bis zu 150°C) herstellbar. Diese Polymerformulierung lässt sich grundsätzlich auch in Verbindung mit anderen elektronischen Bauelementen einsetzen.

Dabei ist es vorteilhaft, wenn mindestens ein Basispolymer ein phenolhaltiges Polymer oder Copolymer, insbesondere Poly-4-vinyl-phenol, Poly-4-vinylphenol-co-methacrylsäure-2-hydroxyethylester oder Poly-4-vinylphenol-comethacrylsäuremethylester ist.

Vorteilhafterweise ist mindestens eine Di- bzw. Tribenzylalkoholverbindung als elektrophile Vernetzerkomponente 4-Hydroxymethyl-benzylalkohol.

Es ist vorteilhaft, wenn mindestens eine Vernetzerkomponente eine der folgenden Strukturen aufweist:

| | | | |
|---|---|---|---|
| 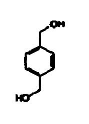 | 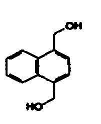 | 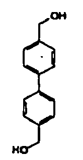 | 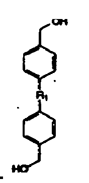 |
| 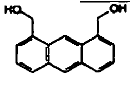 | 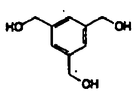 | 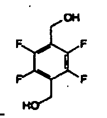 | |

Für R₁ gilt -O-, -S-, -SO₂-, -S₂-, -(CH₂)ₓ- wobei x=1-10, ausserdem:

| | | | |
|---|---|---|---|
| -C=C- | -C≡C- | 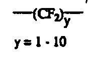 | 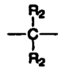 |
| 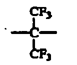 | 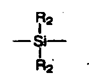 | 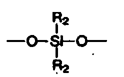 | 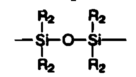 |
| 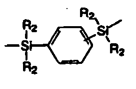 | 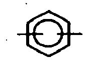 | 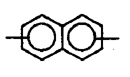 | 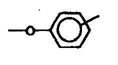 |

| | | | |
|---|---|---|---|
| 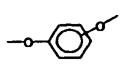 | 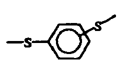 | 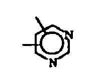 | 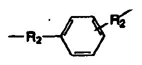 |
| 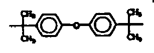 | 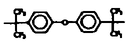 | 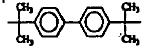 | 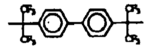 |
| 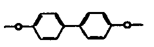 | | | |

Für R₂ gilt: Alkyl mit 1 bis 10 Kohlenstoffatomen oder Aryl

Mit Vorteil wird als Photosäuregenerator mindestens eine Verbindung verwendet, die bei Bestrahlung mit UV-Licht eine Photosäure zur Übertragung eines Protons auf die Hydroxylgruppe eines Benzylalkohols generiert, insbesondere ein Sulfonium- oder ein Iodonium-Salz.

Vorteilhafte Lösungsmittel sind ein Alkohol, insbesondere n-Butanol, Propylenglykolmonomethyletheracetat (PGMEA), Dioxan, N-Methylpyrolidon (NMP), γ-Butyrolacton, Xylen oder ein Gemisch.

Für eine gute Verarbeitbarkeit ist es vorteilhaft, wenn der Anteil an Basispolymer, Vernetzerkomponente und Photosäuregenerator eine Anteil zwischen 5 und 20 Masse-% aufweist.

Die Aufgabe wird auch durch ein Verfahren zur Herstellung einer integrierten Schaltung, insbesondere eines OFET mit einer Dielektrikumsschicht, mit den Merkmalen des Anspruchs 1 gelöst. Erfindungsgemäß wird
a) eine Polymerformulierung gemäß Anspruch 1 auf ein Substrat, insbesondere mit einer vorstrukturierten Gateelektrode aufgebracht, anschließend.
b) wird eine photoinduzierte Vernetzungsreaktion zur Bildung der Gatedielektrikumsschicht durchgeführt.

Zur Herstellung eines OFET wird anschließend vorteilhafterweise mindestens eine weitere Strukturierung zum Aufbau des OFET vorgenommen.

Mit Vorteil wird die photoinduzierte Vernetzungsreaktion durch die Bestrahlung mit UV-Strahlung in Gang gesetzt. Besonders vorteilhaft ist es, wenn nach der Belichtung ein Temperierschritt, insbesondere ein Post Exposure Bake Schritt, erfolgt. Dabei ist es vorteilhaft, wenn die Temperatur im Temperierschritt maximal 140°C, insbesondere 100° C beträgt. Nach dem Post Exposure Bake (PEB) ist esv vorteilhaft, wenn mindestens eine weitere Strukturierung zum Aufbau des OFET erfolgt.

Vorteilhafterweise erfolgt das Aufbringen der Polymerformulierung durch Aufschleudern, Drucken oder Sprühen.

Die Vernetzungsreaktion erfolgt mit Vorteil unter einer Inertgas-, insbesondere einer N₂-Atmosphäre.

Nach dem Aufbringen der Polymerformulierung und der Herstellung des Polymerfilms ist es vorteilhaft eine Trocknung, insbesondere bei 100 °C durchzuführen.

Zur Herstellung des OFET ist es dann vorteilhaft, auf die Gatedielektrikumsschicht eine Source-Drain-Schicht aufzubringen.

Schließlich ist es vorteilhaft, wenn auf die Source-Drain-Schicht eine aktive Schicht zur Bildung eines OFET, insbesondere aus dem halbleitenden Pentazen aufgebracht wird.

Vorteilhafterweise wird auf die aktive Schicht eine Passivierungsschicht angeordnet.

Die Erfindung wird nachfolgend unter Bezugnahme auf die Figuren der Zeichnungen an mehreren Ausführungsbeispielen näher erläutert. Es zeigen:
- Fig. 1: eine schematische Darstellung eines organischen Feldeffekttransistors;
- Fig. 2: Beispiel einer photoinduzierten Vernetzungsreaktion eines polymeren Gatedielektrikums mit PVP und 4- Hydroxymethylbenzylalkohol als Vernetzer;
- Fig. 3a: Ausgangskennlinienschar eines OFET mit elektrophil vernetzten Gatedielektrikum;
- Fig. 3b: Durchgangskennlinienschar eines OFET mit elektrophil vernetzten Gatedielektrikum;
- Fig. 4: Durchzeichnung eines Oszilloskopbildes

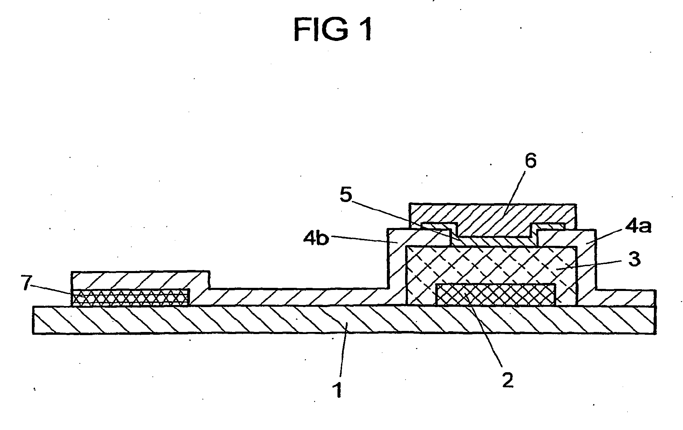

OFETs sind elektronische Bauteile, die aus mehreren Schichten (Lagen) bestehen, welche alle strukturiert sind, um durch Verbindungen einzelner Schichten integrierte Schaltungen zu generieren. Dabei zeigt Fig. 1 den prinzipiellen Aufbau eines solchen Transistors in einer Bottom-Kontakt Architektur.

Auf einem Substrat 1 ist eine Gatelektrode 2 angeordnet, die von einer Gatedielektrikumsschicht 3 überdeckt ist. Wie später noch erläutert wird, stellen bei einer Ausführungsform des erfindungsgemäßen Verfahrens das Substrat 1 mit der bereits darauf angeordneten Gateelektrode 2 das Ausgangsmaterial dar, auf das die Gatedielektrikumsschicht 3 aufgebracht wird. Auf der Gatedielektrikumsschicht 3 sind eine Drainschicht 4a und eine Sourceschicht 4b angeordnet, die beide mit der aktiven halbleitenden Schicht 5 in Verbindung stehen. Über der aktiven Schicht 5 ist eine Passivierungsschicht 6 angeordnet.

Die Sourceschicht 4b stellt eine Verbindung zur Interconnectschicht 7 her.

Entscheidend für die das hier beschriebene Ausführungsbeispiel der Erfindung ist die Deposition und Bearbeitung der Gatedielektrikumsschicht 3.

Die erfindungsgemäßen Schaltungen und deren Herstellung lösen das Problem der Bereitstellung von OFETs mit Gatedielektrikumsschichten insbesondere mit organischen ICs mit hervorragenden mechanischen, chemischen und elektrischen Eigenschaften bei gleichzeitig niedrigen Prozesstemperaturen.

Dabei weist ein OFET eine Dielektrikumsschicht auf, die aus einer Mischung (Polymerformulierung) mit grundsätzlich vier Bestandteilen herstellbar ist: ein Basispolymer, eine Vernetzerkomponente, einen Photosäuregenerator und ein Lösungsmittel. Eine hier beispielhaft angeführte Ausführungsform der erfindungsgemäßen Schaltung weist eine Polymerformulierung mit folgenden Bestandteilen auf
a) als vernetzbares Basispolymer PVP,
b) als eine elektrophile Vernetzerkomponente 4-hydroxymethylbenzylalkohol,
c) als Photosäuregenerator (PAG) Triphenylsulfonium-hexaflat,
d) als Lösungsmittel z.B. Alkohole, PGMEA.

Diese Polymerformulierung wird auf ein entsprechend vorbereitetes Substrat 1 (Gatestrukturen 2 sind bereits auf dem Substrat 1 definierte aufgebracht. Die Polymerformulierung kann z.B. aufgedruckt, aufgeschleudert oder aufgesprüht werden. Durch anschließendendes Trocknen bei moderaten Temperaturen (ca. 100°C) wird die Polymerformulierung auf der Unterlage fixiert.

Daran anschließend erfolgt ein Belichtungschritt mit UV-Licht, wobei die Wellenlänge und die Dauer der UV-Bestrahlung von dem verwendeten Photosäuregenerator abhängt. Aus dem Photosäuregenerator wird eine Photosäure generiert, die in einem folgenden Temperierschritt (maximal 140°C, Post Exposure Bake (PEB)) eine Vernetzungsreaktion initiiert.

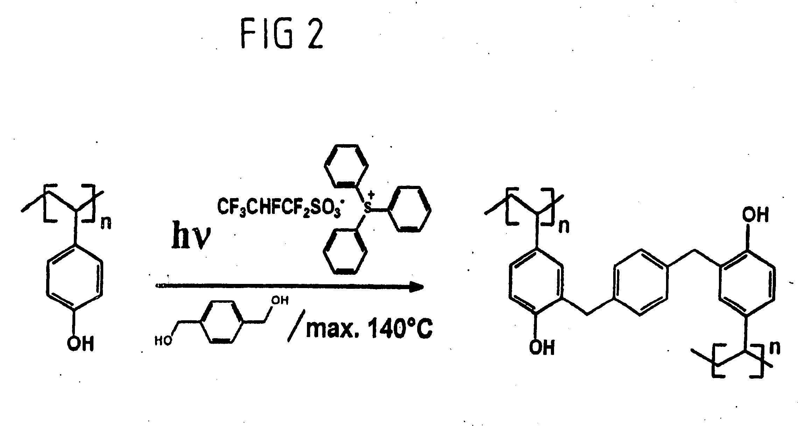

Fig. 2 zeigt die photoinduzierte elektrophile Vernetzungsreaktion eines polymeren Gatedielektriums am Beispiel von PVP mit 4-Hydroxymethylbenzylalkohol als Vernetzerkomponente. Als Photosäuregenerator wird Triphenylsulfonium-hexaflat verwendet.

Durch die photochemisch induzierte Vernetzungsreaktion werden Löslichkeitsunterschiede zwischen vernetztem und unvernetztem Material erzeugt. Durch die Verwendung von Masken ist damit eine Definition von belichteten und unbelichteten Bereichen möglich, was zur Strukturierung der Gatedielektrikumsschicht 3 verwendet werden kann.

Die Benutzung des Verfahrens verringert die benötigte Vernetzungstemperatur um mehr als 60°C, verglichen mit den bisher bekannten Methoden (siehe Artikel von Halik et al. (2002)). Die verwendeten Temperaturen sind unkritisch für das Substrat.

Das Basispolymer bestimmt dabei die Grundeigenschaften der Gatedielektrikumsschicht 3. Als Basispolymere eigenen sich prinzipiell alle phenolhaltigen Polymere und deren Copolymere, wie z.B. Poly-4-vinyl-phenol, Poly-4-vinylphenol-comethacrylsäure-2-hydroxyethylester oder Poly-4-vinylphenol-comethacrylsäuremethylester.

Durch die Wahl der Vernetzerkomponente und deren Konzentration in der Polymerformulierung lassen sich die mechanischen Eigenschaften der Polymerschicht und die Resistenz gegenüber Chemikalien maßgeblich steuern.

Durch die Wahl des Photosäuregenerators lassen sich Wellenlänge und Belichtungsdosis der Initiierung der Vernetzungsreaktion steuern. Dabei bestimmt die Temperatur des Post Expore Bakes (PEB) die Dauer des Vernetzungsschrittes, da dieser wesentlich durch die Diffusion der photogenerierten Säure bestimmt wird.

Die Wahl des Lösungsmittels bestimmt die Filmbildungseigenschaften der Formulierung.

Im Folgenden werden als Beispiele zwei Polymerformulierungen beschrieben, die sich lediglich im Anteil des Vernetzers unterscheiden.

Formulierung 1 ist eine 10%-ige Lösung in Propylenglykolmonomethyletheracetat (PGMEA). Dabei liegen 100 Teile Basispolymer, 10 Teile Vernetzer und 2.5 Teile Photosäuregenerator vor.

Eine Mischung aus 2 g PVP (MW ca. 20.000) als Basispolymer und 200 mg 4-Hydroxymethyl-benzylalkohol als Vernetzer werden in 20.5g PGMEA als Lösungsmittel auf einer Rüttelapparatur gelöst (ca. 3 Stunden).

Anschließend werden 50 mg Triphenylsulfonium-hexaflat als Photosäuregenerator zugegeben und die gesamte Lösung eine weitere Stunde geschüttelt. Vor Benutzung wird die Polymerlösung durch einen 0.2 µm Filter filtriert.

Formulierung 2 ist eine 10%-ige Lösung in PGMEA. Dabei liegen 100 Teile Basispolymer, 20 Teile Vernetzer und 2.5 Teile Photosäuregenerator vor. Der Anteil an Vernetzer ist also doppelt so hoch wie in der Formulierung 1.

Eine Mischung aus 2 g PVP (MW ca. 20.000) als Basispolymer und 400 mg 4-Hydroxymethyl-benzylalkohol als Vernetzer werden in 20.5g PGMEA als Lösungsmittel auf einer Rüttelapparatur gelöst (ca. 3 Stunden). Anschließend werden 50 mg Triphenylsulfonium-hexaflat als Photosäuregenerator zugegeben und die gesamte Lösung eine weitere Stunde geschüttelt. Vor Benutzung wird die Polymerlösung durch einen 0.2 µm Filter filtriert.

### Filmpräparation:

2 ml der Formulierung 1 wurden mittels spin coater bei 4000 U/min für 22 s auf ein vorbereitetes Substrat (PEN (Polyethylennaphtalat) mit Ti-Gatestrukturen) aufgebracht. Anschließend wird bei 100°C für 2 min auf einer Hotplate getrocknet. Anschließend wird die Schicht belichtet (Wellenlänge 365 nm, Dauer 30 Sekunden, Bestrahlungsstärke 7mW/cm²) _{.}

Anschließend erfolgt bei 140°C im Ofen unter 400 mbar N₂-Atmosphäre für 20 Minuten ein Post Exposure Bake.

Die Filmpräparation für Formulierung 2 erfolgt analog. Strukturierung der Gatedielektrikumsschicht:

Die Strukturierung erfolgt wie in den Beispielen angegeben, mit der Ausnahme, dass die quervernetzte Polymerschicht (Gatedielektrikumsschicht 3) mit einer Hellfeld-Chrommaske (Chrome on Glas COG) belichtet wird. Nach dem Post Exposure Bake Schritt wird nicht vernetztes Dielektrikum (d.h. Stellen der Dielektrikumsschicht 3, die nicht belichtet wurden) mit Aceton herausgelöst. An den belichteten Stellen verbleibt die strukturierte Dielektrikumsschicht 3.

Anschließend wir die Source-Drain Schicht 4a, 4b nach Standardverfahren abgeschieden und strukturiert (30 nm Au thermisch aufgedampft, photolithographische Strukturierung und nasschemisches Ätzen mit I₂/KI-Lösung)

Die Schichtdicke der Gatedielektrikumsschichten 2 beträgt für Formulierung 1 = 200nm. Die Rauhigkeit der Schicht beträgt 0,7 nm auf 50 µm.

Die Schichtdicke der Gatedielektrikumsschichten beträgt für Formulierung 2 = 210nm. Die Rauhigkeit der Schicht beträgt 0,7 nm auf 50 µm.

Die Transistoren bzw. Schaltungen werden fertiggestellt, indem die aktive Komponente 5 (hier Pentazen) thermisch aufgedampft wird. Bis auf die Passivierungsschicht 6 ist damit der Aufbau eines OFET gemäß Fig. 1 hergestellt.

Hier werden Ausführungsformen für eine Polymerformulierung und deren Verwendung zur Herstellung von Gatedielektrikumsschichten 3 bei niedrigen Temperaturen für den Einsatz in integrierten Schaltungen basierend auf OFETs beschrieben. Diese Gatedielektrikumsschichten 3 zeichnen sich neben der geringen Prozesstemperatur für deren Herstellung durch hervorragende thermische, chemische, mechanische und elektrische Eigenschaften aus.

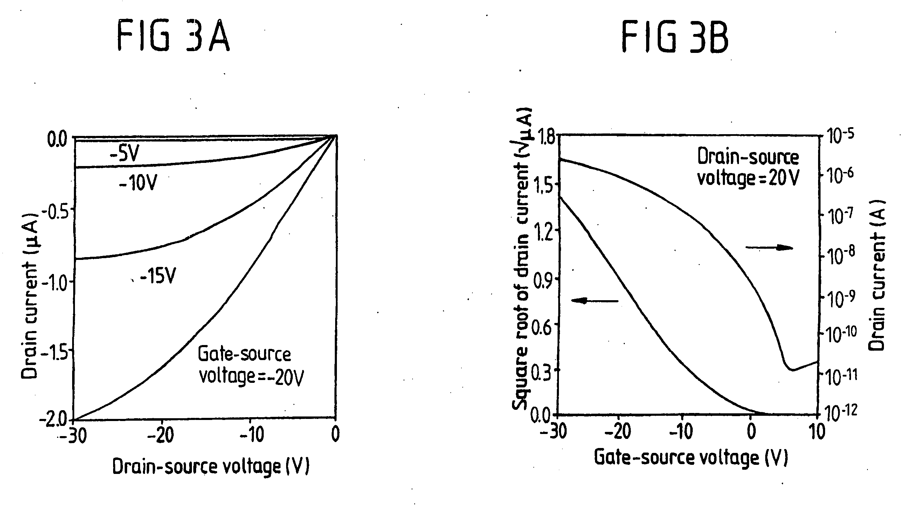

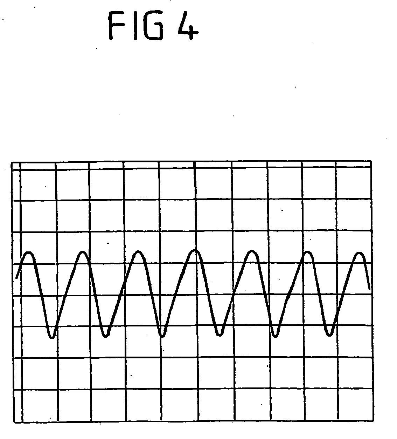

In Fig. 3a ist eine Ausgangskennlinienschar eines Pentazen-OFET mit elektrophil vernetztem Gatedielektrium dargestellt. Fig. 3b zeigt für den gleichen Aufbau die Durchgangskennlinien eines OFET (µ=0,8 cm²/Vs, on/off ratio = 10⁵). In Fig. 4 ist eine Durchzeichnung einer Ozilloskop-Darstellung wiedergegeben. Dabei wird die Kennlinie eines 5 Stufen Ringoszillators dargestellt, wobei der Ringoszillator mit einer Signalverzögerung von 80 µsec pro Stufe arbeitet.

In Zusammenhang mit den Figuren wurde als Ausführungsbeispiel ein OFET als integrierte Schaltung verwendet. Grundsätzlich kann die erfindungsgemäße integrierte Schaltung aber auch einen anderen Aufbau haben, bei dem eine Dieelektrikumsschicht verwendet wird.

Die Erfindung beschränkt sich in ihrer Ausführung nicht auf die vorstehend angegebenen bevorzugten Ausführungsbeispiele. Vielmehr ist eine Anzahl von Varianten denkbar, die von der erfindungsgemäi3en Vorrichtung und dem erfindungsgemäßen Verfahren, wie in den Ansprüchen dargestellt, auch bei grundsätzlich anders gearteten Ausführungen Gebrauch machen.

### Bezugszeichenliste.

- 1: Substrat
- 2: Gateelektrode
- 3: Gatedielektrikumsschicht
- 4a: Drainschicht
- 4b: Sourceschicht
- 5: Aktive Schicht
- 6: Passivierungsschicht
- 7: Interconnectschicht

## Patentansprüche

1. Integrierte Schaltung mit einem organischen FeldeffektTransistor (OFET) mit einer Dielektrikumsschicht,
herstellbar durch
eine Polymerformulierung bestehend aus
a) 100 Teilen mindestens eines vernetzbaren Basispolymers aus der Gruppe umfassend Poly-4-vinyl-phenol, Poly-4-vinylphenol-co-methacrylsäure-2-hydroxyethylester oder Poly-4-vinylphenol-co-methacrylsäuremethylester,
b) 10 bis 20 Teilen 4-Hydroxymethyl-benzylalkohol als elektrophile Vernetzerkomponente,
c) 0,2 bis 10 Teilen Triphenylsulfonium-hexaflat als Photosäuregenerator gelöst in
d) mindestens einem Lösungsmittel.

2. Integrierte Schaltung nach Anspruch 1, **dadurch gekennzeichnet, dass** mindestens ein Lösungsmittel ein Alkohol aus der Gruppe umfassend n-Butanol, Propylenglykolmonomethyletheracetat (PGMEA), Dioxan, N-Methylpyrolidon (NMP), γ-Butyrolacton, Xylen oder ein Gemisch derselben.

3. Integrierte Schaltung nach mindestens einem der vorherigen Ansprüche, **gekennzeichnet durch** einen Anteil an Basispolymer, Vernetzerkomponente und Photosäuregenerator mit einem Anteil zwischen 5 und 20 Masse-%.

4. Verfahren zur Herstellung einer integrierten Schaltung mit einem OFET mit einer Dielektrikumsschicht,
**dadurch gekennzeichnet, dass**
a) eine Polymerformulierung gemäß Anspruch 1 auf ein Substrat (1), insbesondere mit einer vorstrukturierten Gateelektrode (2) aufgebracht wird, und anschließend
b) eine photoinduzierte Vernetzungsreaktion zur Bildung von vernetzten Bereichten der Gatedielektrikumsschicht (3) erfolgt.

5. Verfahren nach Anspruch 4, **dadurch gekennzeichnet, dass** die photoinduzierte Vernetzungsreaktion durch die Bestrahlung mit UV-Strahlung in Gang gesetzt wird.

6. Verfahren nach Anspruch 4 oder 5, **dadurch gekennzeichnet, dass** nach der Belichtung ein Temperierschritt erfolgt.

7. Verfahren nach Anspruch 6, **dadurch gekennzeichnet, dass** die Temperatur im Temperierschritt maximal 140°C beträgt.

8. Verfahren nach mindestens einem der Ansprüche 4 bis 7, **dadurch gekennzeichnet, dass** nach dem Post Exposure Bake (PEB) mindestens eine weitere Strukturierung zum Aufbau des OFET erfolgt.

9. Verfahren nach mindestens einem der Ansprüche 4 bis 8, **dadurch gekennzeichnet, dass** das Aufbringen der Polymerformulierung durch Aufschleudern, Drucken oder Sprühen erfolgt.

10. Verfahren nach mindestens einem der Ansprüche 4 bis 9, **dadurch gekennzeichnet, dass** die Vernetzungsreaktion unter einer Inertgas-Atmosphäre erfolgt.

11. Verfahren nach mindestens einem der Ansprüche 4 bis 10, **dadurch gekennzeichnet, dass** nach dem Aufbringen der Polymerformulierung eine Trocknung, insbesondere bei 100°C erfolgt.

12. Verfahren nach mindestens einem der Ansprüche 4 bis 11, **dadurch gekennzeichnet, dass** auf die Gatedielektrikumsschicht (3) eine Source-Drain-Schicht (4a, 4b) aufgebracht wird.

13. Verfahren nach mindestens einem der Ansprüche 4 bis 12, **dadurch gekennzeichnet, dass** auf die Source-Drain-Schicht (4a, 4b) eine aktive Schicht (5) zur Bildung eines OFET aufgebracht wird.

14. Verfahren nach mindestens einem der Ansprüche 4 bis 13, **dadurch gekennzeichnet, dass** auf der aktiven Schicht (5) eine Passivierungsschicht (6) angeordnet wird.

15. Verfahren nach Anspruch 4 oder 5, **dadurch gekennzeichnet, dass** nach der Belichtung ein Post Exposure Bake Schritt erfolgt.

16. Verfahren nach Anspruch 6, **dadurch gekennzeichnet, dass** die Temperatur im Temperierschritt maximal 100° C beträgt.

17. Verfahren nach mindestens einem der Ansprüche 4 bis 9, **dadurch gekennzeichnet, dass** die Vernetzungsreaktion unter einer N2-Atmosphäre erfolgt.

18. Verfahren nach mindestens einem der Ansprüche 4 bis 12, **dadurch gekennzeichnet, dass** auf die Source-Drain-Schicht (4a, 4b) eine aktive Schicht aus Pentazen (5) zur Bildung eines OFET-aufgebracht wird.

## Claims

1. Integrated circuit comprising an organic field effect transistor (OFET), having a dielectric layer,
obtainable via
a polymer formulation consisting of
a) 100 parts of at least one crosslinkable base polymer from the group consisting of poly-4-vinylphenol, poly-4-vinylphenol-co-2-hydroxyethyl methacrylate or poly-4-vinylphenol-co-methyl methacrylate,
b) from 10 to 20 parts of 4-hydroxymethylbenzyl alcohol as an electrophilic crosslinking component,
c) from 0.2 to 10 parts of triphenylsulphonium hexaflate as photo acid generator dissolved in
d) at least one solvent.

2. Integrated circuit according to Claim 1, **characterized in that** at least one solvent is an alcohol from the group consisting of n-butanol, propylene glycol monomethyl ether acetate (PGMEA), dioxane, N-methylpyrrolidone (NMP), γ-butyrolactone, xylene or a mixture thereof.

3. Integrated circuit according to at least one of the preceding claims, **characterized by** a proportion of base polymer, crosslinking component and photo acid generator of from 5 to 20% by mass.

4. Method for producing an integrated circuit comprising an OFET having a dielectric layer,
**characterized in that**
a) a polymer formulation according to Claim 1 is applied to a substrate (1), in particular having a prestructured gate electrode (2), and then
b) a photoinduced crosslinking reaction for the formation of crosslinked parts of the gate dielectric layer (3) is effected.

5. Method according to Claim 4, **characterized in that** the photoinduced crosslinking reaction is initiated by exposure to UV radiation.

6. Method according to Claim 4 or 5, **characterized in that**, after the exposure to light, a heating step is effected.

7. Method according to Claim 6, **characterized in that** the temperature in the heating step is not more than 140°C.

8. Method according to at least one of Claims 4 to 7, **characterized in that**, after the post exposure bake (PEB), at least one further structuring for producing the OFET is effected.

9. Method according to at least one of Claims 4 to 8, **characterized in that** the polymer formulation is applied by spin coating, printing or spraying.

10. Method according to at least one of Claims 4 to 9, **characterized in that** the crosslinking reaction is effected under an inert gas atmosphere.

11. Method according to at least one of Claims 4 to 10, **characterized in that**, after the application of the polymer formulation, drying is effected, in particular at 100°C.

12. Method according to at least one of Claims 4 to 11, **characterized in that** a source-drain layer (4a, 4b) is applied to the gate dielectric layer (3).

13. Method according to at least one of Claims 4 to 12, **characterized in that** an active layer (5) for the formation of an OFET is applied to the source-drain layer (4a, 4b).

14. Method according to at least one of Claims 4 to 13, **characterized in that** a passivating layer (6) is arranged on the active layer (5).

15. Method according to Claim 4 or 5, **characterized in that**, after the exposure to light, a post exposure bake step is effected.

16. Method according to Claim 6, **characterized in that** the temperature in the heating step is not more than 100°C.

17. Method according to at least one of Claims 4 to 9, **characterized in that** the crosslinking reaction is effected under an N₂ atmosphere.

18. Method according to at least one of Claims 4 to 12, **characterized in that** an active layer comprising pentacene (5) for the formation of an OFET is applied to the source-drain layer (4a, 4b).

## Revendications

1. Circuit intégré comprenant un transistor organique à effet de champ (TOEC) comprenant une couche diélectrique, pouvant être préparé par une formulation polymère, constituée par
a) 100 parties d'au moins un polymère de base réticulable du groupe comprenant le poly-4-vinylphénol, le poly-4-vinylphénol-co-ester 2-hydroxyéthylique de l'acide méthacrylique ou poly-4-vinylphénol-co-ester méthylique de l'acide méthacrylique,
b) 10 à 20 parties d'alcool 4-hydroxyméthylbenzylique comme composant réticulant électrophile,
c) 0,2 à 10 parties d'hexaflate de triphénylsulfonium comme photogénérateur d'acide dissous dans
d) au moins un solvant.

2. Circuit intégré selon la revendication 1, **caractérisé en ce qu'**au moins un solvant est un alcool du groupe comprenant le n-butanol, le monométhylétheracétate de propylèneglycol (PGMEA), le dioxane, la N-méthylpyrrolidone (NMP), la γ-butyrolactone, le xylène ou un mélange de ceux-ci.

3. Circuit intégré selon au moins l'une quelconque des revendications précédentes, **caractérisé par** une proportion de polymère de base, un composant réticulant et un photogénérateur d'acide en une proportion entre 5 et 20% en masse.

4. Procédé pour la réalisation d'un circuit intégré présentant un TOEC avec une couche diélectrique, **caractérisé en ce que**
a) une formulation polymère selon la revendication 1 est appliquée sur un substrat (1), en particulier avec une électrode grille (2) préstructurée, puis
b) une réaction de réticulation photoinduite est réalisée pour la formation de zones réticulées de la couche diélectrique à grille (3).

5. Procédé selon la revendication 4, **caractérisé en ce que** la réaction de réticulation photoinduite est démarrée par l'irradiation avec un rayonnement UV.

6. Procédé selon la revendication 4 ou 5, **caractérisé en ce qu'**une étape d'équilibrage thermique a lieu après l'exposition à la lumière.

7. Procédé selon la revendication 6, **caractérisé en ce que** la température dans l'étape d'équilibrage thermique est d'au maximum 140°C.

8. Procédé selon au moins l'une quelconque des revendications 4 à 7, **caractérisé en ce qu'**après la cuisson post exposition (Post Exposure Bake - PEB) au moins une autre structuration pour l'élaboration du TOEC est réalisée.

9. Procédé selon au moins l'une quelconque des revendications 4 à 8, **caractérisé en ce que** l'application de la formulation polymère est réalisée par rotation, impression ou pulvérisation.

10. Procédé selon au moins l'une quelconque des revendications 4 à 9, **caractérisé en ce que** la réaction de réticulation est réalisée sous une atmosphère de gaz inerte.

11. Procédé selon au moins l'une quelconque des revendications 4 à 10, **caractérisé en ce qu'**après l'application de la formulation polymère a lieu un séchage, en particulier à 100°C.

12. Procédé selon au moins l'une quelconque des revendications 4 à 11, **caractérisé en ce qu'**on applique sur la couche diélectrique à grille (3) une couche source-drain (4a, 4b).

13. Procédé selon au moins l'une quelconque des revendications 4 à 12, **caractérisé en ce qu'**on applique sur la source-drain (4a, 4b) une couche active (5) pour la réalisation d'un TOEC.

14. Procédé selon au moins l'une quelconque des revendications 4 à 13, **caractérisé en ce qu'**on dispose sur la couche active (5) une couche de passivation (6).

15. Procédé selon la revendication 4 ou 5, **caractérisé en ce qu'**après l'exposition à la lumière est réalisée une étape de cuisson post exposition.

16. Procédé selon la revendication 6, **caractérisé en ce que** la température dans l'étape d'équilibrage thermique est d'au maximum 100°C.

17. Procédé selon au moins l'une quelconque des revendications 4 à 9, **caractérisé en ce que** la réaction de réticulation est réalisée sous une atmosphère de N₂.

18. Procédé selon au moins l'une quelconque des revendications 4 à 12, **caractérisé en ce qu'**on applique sur la source-drain (4a, 4b) une couche active en pentazène (5) pour la réalisation d'un TOEC.
